# DEMANDE DE BREVET EUROPEEN

(11) **EP 4 797 903 A1**
(43) Date de publication de la demande: **26.08.2026**
(21) Numéro de dépôt: 26159423.8
(22) Date de dépôt: 18.02.2026
(51) Int. Cl.: H10D 30/47, H10D 30/01, H10D 62/17, H10D 64/00, H10D 62/815, H10D 62/854, H10D 62/85

(54) **TRANSISTOR HEMT ET SON PROCÉDÉ DE FABRICATION**

(30) Priorité: 24.02.2025 FR 2501892
(71) Demandeur: STMicroelectronics International N.V., 1228 Plan-les-Ouates, Geneva (CH)
(72) Inventeur: CONSTANT, Aurore, 37100 TOURS (FR); ZEGHOUANE, Mohammed, 37100 TOURS (FR); IUCOLANO, Ferdinando, 95030 GRAVINA DI CATANIA (IT)
(74) Mandataire: Cabinet Beaumont

(57) **Abrégé**

La présente description concerne un transistor (43) HEMT comportant :
- une première couche semiconductrice (13) ; et
- une grille (45) disposée sur une première face de la première couche semiconductrice (13),
dans lequel la grille (45) comprend une alternance d'au moins deux premières couches (451) et d'au moins trois deuxièmes couches (453), les premières couches (451) étant dopées en magnésium et en au moins l'un des éléments dopants choisi parmi le silicium et l'oxygène et les premières couches (451) ayant une concentration en éléments dopants supérieure à la concentration en éléments dopants dans les deuxièmes couches (453).

## Description

### Domaine technique

La présente description concerne de façon générale le domaine des transistors et plus particulièrement le domaine des transistors à haute mobilité électronique aussi appelés HEMT (de l'anglais "High Electron Mobility Transistor").

### Technique antérieure

Les transistors HEMT reposent sur une hétérojonction en surface de laquelle se forme un gaz bidimensionnel d'électrons appelé 2DEG.

Il existe un besoin d'amélioration des transistors HEMT et de leurs procédés de fabrication.

### Résumé de l'invention

Pour cela, un mode de réalisation prévoit un transistor HEMT comportant :
- une première couche semiconductrice ; et
- une grille disposée sur une première face de la première couche semiconductrice,
dans lequel la grille comprend une alternance d'au moins deux premières couches et d'au moins trois deuxièmes couches, les premières couches étant dopées en magnésium et en au moins l'un des éléments dopants choisi parmi le silicium et l'oxygène et les premières couches ayant une concentration en éléments dopants supérieure à la concentration en éléments dopants dans les deuxièmes couches.

Selon un mode de réalisation, la grille comprend au moins quatre premières couches et au moins cinq deuxièmes couches.

Selon un mode de réalisation, chaque première couche est en contact avec une deuxième couche sus-jacente et une deuxième couche sous-jacente.

Selon un mode de réalisation, la concentration en magnésium dans les premières couches est supérieure à 1.10¹⁷ atomes/cm³.

Selon un mode de réalisation, la concentration en oxygène et/ou en silicium dans les premières couches est supérieure à 1.10¹⁶ atomes/cm³.

Selon un mode de réalisation, la concentration en magnésium dans les deuxièmes couches est inférieure à 1.10¹⁷ atomes/cm³.

Selon un mode de réalisation, la face inférieure de la grille correspond à la face inférieure d'une deuxième couche inférieure.

Selon un mode de réalisation, la face supérieure de la grille correspond à la face supérieure d'une deuxième couche supérieure.

Selon un mode de réalisation, la deuxième couche supérieure a une épaisseur supérieure aux autres deuxièmes couches de la grille.

Selon un mode de réalisation, la grille comprend, entre la deuxième couche supérieure et une première couche inférieure, une couche en nitrure d'aluminium, ladite couche en nitrure d'aluminium étant en contact avec la deuxième couche supérieure.

Selon un mode de réalisation, les deuxièmes couches ont toutes la même épaisseur.

Selon un mode de réalisation, la grille comprend en outre une alternance d'au moins deux troisièmes couches et d'au moins trois quatrièmes couches, les troisièmes couches étant dopées majoritairement en éléments dopants de silicium et/ou d'oxygène, et les troisièmes couches ayant une concentration en éléments dopants supérieure à la concentration en éléments dopants dans les quatrièmes couches, l'alternance des premières et deuxièmes couches étant disposée dans une partie inférieure de la grille et l'alternance des troisièmes et quatrièmes couches étant disposée dans une partie supérieure de la grille, et
les premières couches étant dopées majoritairement en éléments dopants de magnésium.

Un autre mode de réalisation prévoir un procédé de formation d'un transistor HEMT comportant les étapes successives suivantes :
a) former une première couche semiconductrice ;
b) former au moins deux premières couches en alternance avec au moins trois deuxièmes couches de façon à créer une grille sur une première face de la première couche semiconductrice, les premières couches étant dopées en magnésium et en au moins l'un des éléments dopants choisi parmi le silicium et l'oxygène, et les premières couches ayant une concentration en éléments dopants supérieure à la concentration en éléments dopants dans les deuxièmes couches.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un transistor HEMT ;
la figure 2 est une vue en coupe, partielle et schématique, d'un exemple d'un transistor HEMT selon un premier mode de réalisation ;
la figure 3 est une vue en coupe, partielle et schématique, d'un exemple d'un transistor HEMT selon un deuxième mode de réalisation ;
la figure 4 est une vue en coupe, partielle et schématique, d'un exemple d'un transistor HEMT selon un troisième mode de réalisation ;
la figure 5 est une vue en coupe, partielle et schématique, d'un exemple d'un transistor HEMT selon un quatrième mode de réalisation ;
la figure 6 est une vue en coupe, partielle et schématique, d'un exemple d'un transistor HEMT selon un cinquième mode de réalisation ; et
la figure 7 est une vue en coupe, partielle et schématique, d'un exemple d'un transistor HEMT selon un sixième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications que peuvent avoir les transistors HEMT décrits ne sont pas détaillées, les modes de réalisation étant compatibles avec les applications usuelles des transistors HEMT. On s'intéresse ici tout particulièrement au domaine des transistors HEMT dits de puissance, capables de tenir des tensions relativement élevées à l'état bloqué, par exemple des tensions de l'ordre de 100 à 650 volts. Les transistors décrits peuvent, par exemple, être utilisés dans divers circuits de conversion ou d'adaptation de puissance, par exemple dans des équipements industriels, des dispositifs d'affichage ou d'éclairage, des équipements de télécommunications, des dispositifs automobiles, etc.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

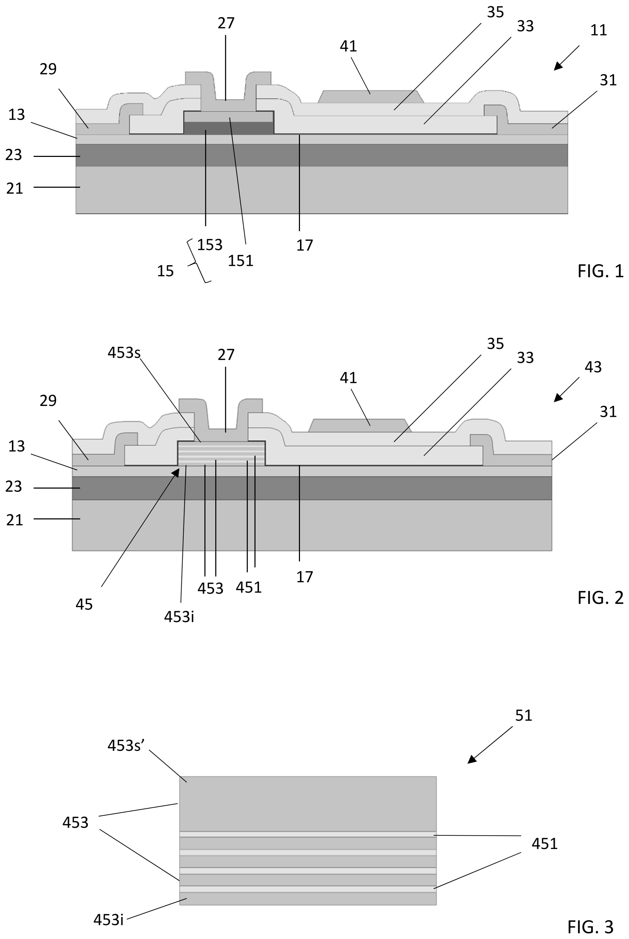

La figure 1 est une vue en coupe, partielle et schématique, d'un exemple d'un transistor HEMT 11 selon un mode de réalisation.

Le transistor HEMT 11 comporte une première couche semiconductrice 13 appelée couche barrière, disposée sur une deuxième couche conductrice 23 appelée couche de canal. La couche semiconductrice 23 est par exemple en contact, par sa face inférieure, avec la face supérieure de la couche conductrice 23. A titre d'exemple, l'empilement comprenant la couche semiconductrice 13 et la couche semiconductrice 23 repose sur un substrat 21. La couche semiconductrice 23 est par exemple en contact, par sa face inférieure, avec la face supérieure du substrat 21. L'interface entre la couche semiconductrice 13 et la couche semiconductrice 23 définit une hétérojonction à la surface de laquelle un gaz bidimensionnel d'électrons 2DEG aussi appelé canal d'électrons est formé.

Les couches semiconductrices 13 et 23 sont par exemple en des matériaux semiconducteurs de type III-V, par exemple à base de nitrure de gallium (GaN). La couche semiconductrice 13 est par exemple en nitrure d'aluminium-gallium (AlGaN). La couche semiconductrice 13 est par exemple en nitrure de gallium (GaN).

A titre d'exemple, le substrat 21 est en un matériau semiconducteur. Le substrat 21 est par exemple en silicium, ou en carbure de silicium. En variante, le substrat 21 est en nitrure d'aluminium. Le substrat 21 comprend par exemple, du côté de sa face supérieure, une couche tampon ("buffer layer" en anglais), non détaillée sur les figures, par exemple en nitrure de gallium. La couche tampon est par exemple en contact, par sa face supérieure, avec la face inférieure de la couche semiconductrice 23.

Le transistor HEMT 11 comporte une grille 15 sur la face supérieure de la couche semiconductrice 13. La grille 15 est par exemple en contact, par sa face inférieure, avec la face supérieure de la couche semiconductrice 13.

La grille 15 est par exemple en un matériau semiconducteur, par exemple en un matériau semiconducteur de type III-V, par exemple en nitrure de gallium. A titre d'exemple, la grille 15 est en un nitrure d'aluminium-gallium dont la formule chimique correspond à AlxGax-1N, dans lequel x est un entier positif.

A titre d'exemple, la grille 15 a une épaisseur totale comprise dans la plage allant de 20 nm à 200 nm, par exemple comprise dans la plage allant de 80 nm à 120 nm, par exemple de l'ordre de 100 nm.

La grille 15 du transistor 11 comprend par exemple, une partie supérieure 151 et une partie inférieure 153.

La partie supérieure 151 de la grille 15 comprend des éléments dopants de type N, par exemple des atomes d'oxygène ou de silicium. La partie inférieure 153 de la grille 15 comprend des éléments dopants de type P, par exemple des atomes de magnésium. Cela permet de définir une jonction PN à l'interface entre la partie inférieure 153 et la partie supérieure 151.

A titre d'exemple, la partie supérieure 151 a une épaisseur comprise entre 10 nm et 100 nm, par exemple comprise dans la plage allant de 30 nm à 70 nm, par exemple de l'ordre de 50 nm.

A titre d'exemple, le transistor HEMT 11 comprend, en outre, une métallisation de contact de source 29 et une métallisation de contact de drain 31. A titre d'exemple, les métallisations de contact 29 et 31 sont à base de titane, de nitrure de titane et/ou d'un alliage d'aluminium et de cuivre. Les métallisations de contact de source 29 et de drain 31 définissent par exemple chacune un contact ohmique avec la couche semiconductrice 13. Les métallisations de contact 29 et 31 sont par exemple situées sur et en contact avec la couche semiconductrice 13, de part et d'autre de la grille 15.

Le transistor HEMT 11 comporte, en outre, une couche de passivation 17 recouvrant les flancs de la grille 15, une partie de la face supérieure de la grille 15 et se prolongeant sur une partie de la face supérieure de la couche semiconductrice 13 non recouverte par la grille 15. A titre d'exemple, la couche de passivation 17 est en contact, par sa face inférieure, avec la face supérieure de la couche semiconductrice 13. La couche de passivation 17 est par exemple en outre en contact avec les flancs de la grille 15. Dans le mode de réalisation de la figure 1, la couche de passivation 17 s'étend latéralement entre les métallisations de contact de source 29 et de drain 31.

La couche de passivation 17 a par exemple une épaisseur comprise dans la plage allant de 2 nm à 20 nm, par exemple comprise dans la plage allant de 2 nm à 10 nm, par exemple de l'ordre de 5 nm. La couche de passivation 17 est par exemple en un matériau diélectrique, par exemple en alumine (Al₂O₃), en dioxyde de silicium (SiO₂), en nitrure de silicium (Si₃N₄) en nitrure d'aluminium (AlN) ou en oxyde d'hafnium (HfO₂).

La grille 15 est par exemple surmontée par une métallisation de contact de grille 27.

A titre d'exemple, la métallisation de contact de grille 27 est en contact, par sa face inférieure, avec la face supérieure de la grille 15. La métallisation de contact de grille 27 s'étend alors à travers la couche 17 qui ne recouvre la face supérieure de la grille 15 que sur sa périphérie.

A titre d'exemple, la métallisation de contact de grille 27 est à base de nitrure de titane et/ou de titane, et/ou de tantale, et/ou un alliage de tungstène et de tantale et/ou un alliage de tungstène et de titane et/ou d'un alliage d'aluminium et de cuivre.

Dans cet exemple, la métallisation 27 définit un contact Schottky avec la grille semiconductrice 15. La grille semiconductrice 15 et la métallisation 27 définissent une diode Schottky dont l'anode correspond à la grille semiconductrice 15 et dont la cathode correspond à la métallisation 27.

Le transistor HEMT 11 comprend par exemple plusieurs niveaux de couches isolantes dans, et par exemple sur, lesquelles sont formés des métallisations.

A titre d'exemple, le transistor HEMT 11 comprend une couche isolante 33 sur et en contact avec la face supérieure de la couche de passivation 17. A titre d'exemple, la couche isolante 33 recouvre l'ensemble de la surface de la couche de passivation 17. La couche isolante 33 est par exemple ouverte en vis-à-vis d'une partie centrale de la face supérieure de la grille 15 de façon à être traversée par la métallisation de contact de grille 27. La couche isolante 33 est par exemple en un matériau diélectrique, par exemple en un oxyde, par exemple en dioxyde de silicium (SiO₂) ou en nitrure de silicium (Si₃N₄).

A titre d'exemple, la métallisation de contact de source 29 se prolonge sur la face supérieure de la couche isolante 33 en direction de grille 15, sans atteindre grille 15. A titre d'exemple, la métallisation de contact de drain 31 se prolonge sur la face supérieure de la couche isolante 33 en direction de grille 15, sans atteindre grille 15.

Le transistor HEMT 11 peut comprendre une deuxième couche isolante 35 recouvrant l'ensemble de la structure et plus particulièrement, la couche 33 et les métallisations de contact de source 29 et de drain 31. La deuxième couche isolante 35 est, par exemple en le même matériau que la couche isolante 33.

Le transistor HEMT 11 peut en outre comprendre une région métallique 41 formée sur, et par exemple en contact avec, la couche isolante 35 entre les métallisations 27 et 31. A titre d'exemple, la région métallique 41 est à base de nitrure de titane et/ou de titane, et/ou de tantale, et/ou un alliage de tungstène et de tantale et/ou un alliage de tungstène et de titane et/ou d'un alliage d'aluminium et de cuivre.

La région métallique 41 a par exemple pour fonction de modifier le profil de la distribution du champ électrique du bord de la grille, situé du côté du drain (le bord droit de la grille en figure 1), et de réduire le pic du champ électrique critique, augmentant ainsi la tension d'avalanche. La région métallique 41 est par exemple appelée "field plates" ou plaques de champ.

Dans le transistor de la figure 1, le canal 2DEG est par exemple normalement fermé ("normally-off" en anglais), c'est-à-dire qu'il est interrompu sous la grille 15 ce qui empêche la circulation d'un courant entre la source et le drain du transistor. On dit que le transistor est à l'état bloqué. Le canal peut être rétabli (c'est à dire rendu passant) par la polarisation de la grille 15. Dans ce cas, un courant peut s'établir entre la source et le drain du transistor. Les modes de réalisation décrits peuvent également s'appliquer à des transistors normalement ouvert ("normally-on" en anglais).

Alors que la couche de passivation 17 joue un rôle important dans la qualité et la durée de vie du transistor, sa présence peut entrainer l'accumulation d'électrons le long des flancs de la grille 15, sous la couche de passivation 17. Ce phénomène est par exemple accentué par l'endommagement des flancs de la grille causé par la gravure de la grille 15. Il en résulte l'apparition de courants de fuite entre la métallisation de contact de grille 27 et les métallisations de source 29 et/ou de drain 31, passant par les flancs de la grille.

La présence d'une jonction PN dans la grille 15 permet de réduire ce phénomène. La métallisation de contact 27 forme alors un contact ohmique avec la partie supérieure 151 de type N de la grille semiconductrice 15. Ainsi, la diode Schottky formée, dans l'exemple de la figure 1, entre la grille semiconductrice 15 et la métallisation 27, est remplacée par une diode PN formée entre la partie inférieure et la partie supérieure de la grille semiconductrice 15.

Toutefois, une jonction nette entre la partie supérieure 151 et la partie inférieure 153 de la grille 15 est difficile à obtenir puisque les atomes de magnésium présents dans la partie inférieure 153 de la grille 15 ont tendance à diffuser dans la partie supérieure 151 de la grille 15 ce qui engendre une modification du dopage de la partie supérieure 151 de la grille 15.

La figure 2 est une vue en coupe, partielle et schématique, d'un exemple d'un transistor HEMT 43 selon un premier mode de réalisation.

Le transistor 43 illustré en figure 2 est similaire au transistor 11 illustré en figure 1 à la différence près que le transistor 43 comprend une grille 45 comprenant une alternance d'une pluralité de premières couches 451 comportant des éléments dopants de type P, ici le magnésium et des éléments dopants de type N, ici au moins l'un choisi parmi le silicium et l'oxygène et d'une pluralité de deuxièmes couches 453, les premières couches 451 ayant une concentration en éléments dopants supérieure à la concentration en éléments dopants dans les deuxièmes couches 453. A titre d'exemple, dans les couches 451, les éléments dopants de type P sont majoritaires par rapport aux éléments dopants de type N.

La présence d'éléments dopants de silicium et/ou de silicium dans les couches 451 permet que les atomes d'hydrogène présents dans les couches 451 se lient à ces éléments dopants plutôt qu'aux éléments dopants de magnésium, laissant libre les éléments dopants de magnésium ce qui engendre, pour une même concentration en éléments dopants de magnésium l'augmentation de la conductivité de type P des couches 451.

A titre d'exemple, la grille 45 comprend au moins 7 couches 451 alternées avec au moins 8 couches 453. A titre d'exemple, la grille 45 comprend au moins 8 couches 451 alternées avec au moins 9 couches 453.

A titre d'exemple, la grille 45 comprend moins de 10 couches 451 alternées avec moins de 11 couches 453. A titre d'exemple, la grille 45 comprend moins de 9 couches 451 alternées avec moins de 10 couches 453.

Les couches 451 ont par exemple une concentration en magnésium supérieure à 1.10¹⁷ atomes/cm³, par exemple comprise dans la plage allant de 1.10¹⁹ atomes/cm³ à 3.10¹⁹ atomes/cm³. Les couches 451 ont par exemple une concentration en oxygène et/ou en silicium supérieure à 1.10¹⁶ atomes/cm³, par exemple supérieure à 1.10¹⁷ atomes/cm³, par exemple de l'ordre de 6.10¹⁷ atomes/cm³.

Les couches 453 ont par exemple une concentration en magnésium inférieure à 1.10¹⁸ atomes/cm³, par exemple inférieure à 1.10¹⁷ atomes/cm³. Les couches 451 ont par exemple une concentration en oxygène et/ou en silicium inférieure à 1.10¹⁶ atomes/cm³.

En figure 2, les couches 451 et 453 s'étendent par exemple sur l'entièreté de la longueur de la grille 45. Les couches 451 et 453 s'étendent par exemple sur l'entièreté de la largeur de la grille 45.

A titre d'exemple, la face inférieure de la grille 45 est définie par une couche 453 référencée 453i. La couche 13 est par exemple en contact avec la grille 45 par la couche 453i.

A titre d'exemple, la face supérieure de la grille 45 est définie par une couche 453 référencée 453s. La métallisation 27 est par exemple en contact avec la grille 45 par la couche 453s.

Chacune des couches 451 est par exemple ainsi en contact, par sa face supérieure, avec une couche 453 et, par sa face inférieure, avec une autre couche 453.

A titre d'exemple, les couches 451 et 453 ont toutes sensiblement la même épaisseur. Chaque couche 451 et 453 a par exemple une épaisseur comprise dans la plage allant de 10 nm à 20 nm, par exemple de l'ordre de 13 nm.

A titre d'exemple, la grille 45 est formée par épitaxie, par exemple à faible température, par exemple à une température inférieure à 950 °C. La grille 45 est par exemple formée lors d'une étape lors de laquelle des éléments dopants sont implantés progressivement au fur et à mesure de la croissance de la grille 45 (dopage in-situ). La formation de la grille 45 comprend par exemple une succession de plusieurs cycles de dopage lors de la croissance par épitaxie de la grille 45. A titre d'exemple, chaque cycle permet la formation d'une paire de couches 451 et 453.

Chaque cycle comprend, pendant une première période, l'implantation des éléments dopants de magnésium et des éléments dopants de silicium et/ou d'oxygène, ce qui permet la formation d'une couche 451, et comprend, pendant une deuxième période, une absence d'implantation des éléments dopants, ce qui permet la formation d'une couche 453. A titre d'exemple, le nombre de cycles réalisés lors de cette étape est égal au nombre de couches 451 et 453 souhaité et défini pour la grille 45.

La figure 3 est une vue en coupe, partielle et schématique, d'un exemple d'une grille 51 de transistor HEMT selon un deuxième mode de réalisation.

La grille 51 illustrée en figure 3 est similaire à la grille 45 du transistor 43 illustré en figure 2 à la différence près que la grille 51 illustrée en figure 3 comprend, du côté de sa face supérieure, une couche 453s' de même nature que la couche 453s de la figure 2 mais présentant une épaisseur supérieure à celle de la couche 453s. Autrement dit, dans l'exemple de la figure 3, la couche supérieure 453s' présente une épaisseur supérieure à celle des autres couches 453 de l'empilement.

A titre d'exemple, la couche 453s' a une épaisseur comprise dans la plage allant de 20 nm à 50 nm, par exemple de l'ordre de 30 nm.

Dans l'exemple représenté, la grille 51 comprend moins de couches 451 et de couches 453 que ce qui est prévu dans la grille 45 de la figure 2.

A titre d'exemple, la grille 51 comprend au moins 5 couches 451 alternées avec au moins 6 couches 453. A titre d'exemple, la grille 51 comprend au moins 6 couches 451 alternées avec au moins 7 couches 453.

A titre d'exemple, la grille 51 comprend moins de 9 couches 451 alternées avec moins de 10 couches 453. A titre d'exemple, la grille 51 comprend moins de 7 couches 451 alternées avec moins de 8 couches 453.

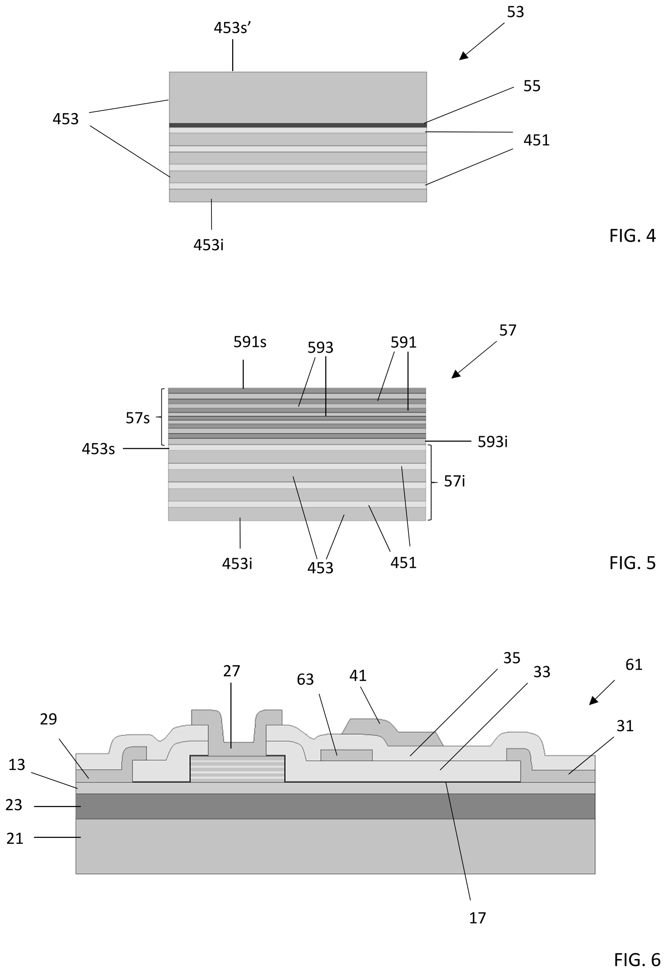

La figure 4 est une vue en coupe, partielle et schématique, d'un exemple d'une grille 53 de transistor HEMT selon un troisième mode de réalisation.

La grille 53 illustrée en figure 4 est similaire à la grille 51 illustrée en figure 3 à la différence près que la grille 53 illustrée en figure 4 comprend en outre, entre la couche supérieure 453s' et la couche 451 sous-jacente, une couche d'arrêt 55 en nitrure d'aluminium (AlN). La couche 55 permet par exemple d'empêcher ou de limiter la diffusion du magnésium de la couche 451 dans la couche 453s'.

La couche d'arrêt 55 est par exemple en contact, par sa face supérieure, avec la couche supérieure 453s'. La couche d'arrêt 55 est en outre, par exemple en contact, par sa face inférieure avec la couche 451 sous-jacente.

La couche d'arrêt 55 s'étend par exemple sur l'entièreté de la longueur de la grille 53. La couche d'arrêt 55 s'étend en outre par exemple sur l'entièreté de la largeur de la grille 53. A titre d'exemple, la couche 55 a une épaisseur comprise dans la plage allant de 10 nm à 15 nm, par exemple de l'ordre de 13 nm.

La figure 5 est une vue en coupe, partielle et schématique, d'un exemple d'une grille 57 de transistor HEMT selon un quatrième mode de réalisation.

La grille 57 illustrée en figure 5 est similaire à la grille 43 du transistor 41 illustré en figure 2 à la différence près qu'une partie inférieure 57i de la grille 57 comprend l'alternance des couches 451 et 453 et qu'une partie supérieure 57s de la grille 57 comprend une alternance d'une pluralité de troisièmes couches 591 dopées majoritairement en éléments dopants de type N, ici du silicium et/ou de l'oxygène et d'une pluralité de quatrièmes couches 593. En figure 5, les troisièmes couches 591 ont une concentration en éléments dopants supérieure à la concentration en éléments dopants dans les quatrièmes couches 591.

Les couches 591 ont par exemple une concentration en oxygène et/ou en silicium supérieure à 1.10¹⁷ atomes/cm³, par exemple de l'ordre de 5.10¹⁸ atomes/cm³.

A titre d'exemple, les couches 591 ont par exemple une concentration en magnésium inférieure à 10¹⁶ atomes/cm³, par exemple inférieure à 10¹⁵ atomes/cm³. A titre d'exemple, les couches 591 ne comprennent pas d'atomes de magnésium.

Les couches 593 ont par exemple une concentration en oxygène et/ou en silicium inférieure à 1.10¹⁶ atomes/cm³.

A titre d'exemple, les couches 593 sont identiques aux couches 453 à la différence près que les couches 593 sont moins épaisses que les couches 453. A titre d'exemple, les couches 593 ont une épaisseur comprise dans la plage allant de 5 nm à 10 nm, par exemple de l'ordre de 7 nm.

A titre d'exemple, les couches 591 ont chacune une épaisseur sensiblement identique à l'épaisseur des couches 593.

A titre d'exemple, la partie supérieure 57s de la grille 57 comprend au moins 2 couches 591 alternées avec au moins 2 couches 593.

A titre d'exemple, la grille 57 comprend moins de couches 451 et 453 que ce qui est prévu dans la grille 45.

A titre d'exemple, dans la partie inférieure 57i de la grille 57, la grille 57 comprend au moins 5 couches 451 alternées avec au moins 6 couches 453. A titre d'exemple, dans la partie inférieure 57i de la grille 57, la grille 57 comprend au moins 6 couches 451 alternées avec au moins 7 couches 453.

A titre d'exemple, dans la partie inférieure 57i de la grille 57, la grille 57 comprend moins de 9 couches 451 alternées avec moins de 10 couches 453. A titre d'exemple, dans la partie inférieure 57i de la grille 57, la grille 57 comprend moins de 7 couches 451 alternées avec moins de 8 couches 453.

A titre d'exemple, la face supérieure de la partie supérieure 57s de la grille 57 est définie par une couche 591 référencée 591s. A titre d'exemple, la face inférieure de la partie supérieure 57s de la grille 57 est définie par une couche 593 référencée 593i.

A titre d'exemple, la face supérieure de la partie inférieure 57i de la grille 57 est définie par une couche 451 référencée 451s. A titre d'exemple, la face inférieure de la partie inférieure 57i de la grille 57 est définie par une couche 453 référencée 453i.

A titre d'exemple, la partie supérieure 57s et la partie inférieure 57i sont en contact l'une de l'autre. Plus précisément, la couche 593i est en contact avec la couche 451s. A titre d'exemple, la partie supérieure 57s s'étend sur l'entièreté de la longueur et la largeur de la grille 57.

A titre d'exemple, la partie supérieure 57s de la grille 57 a une épaisseur comprise dans la plage allant de 10 nm à 50 nm, par exemple de l'ordre de 30 nm. A titre d'exemple, la partie inférieure 57i de la grille 57 a une épaisseur comprise dans la plage allant de 40 nm à 100 nm, par exemple de l'ordre de 70 nm.

Dans ce mode de réalisation, la formation de la grille 57 est par exemple similaire à la formation de la grille 41du transistor 43 à la différence près qu'au cours de la formation de la grille 57, le dopage en magnésium cesse.

A titre d'exemple, une première partie de la formation de la grille 57 comprend la formation de la partie inférieure 57i de la grille 57 similairement à ce qui a été décrit pour la formation de la grille 45.

Dans une seconde partie de la formation de la grille 57, qui correspond à la formation de la partie supérieure 57s, alors que la croissance par épitaxie n'est pas interrompue après la première partie de la formation de la grille 57, plusieurs autres cycles de dopage se succèdent. Dans cette seconde partie, chaque cycle comprend, pendant une troisième durée, l'implantation d'éléments dopants de silicium et/ou d'oxygène permettant la formation d'une couche 591, et comprend, pendant une quatrième durée, l'absence d'implantation d'éléments dopants permettant la formation d'une couche 593. A titre d'exemple, l'implantation des éléments dopants pour la formation des couches 591 ne comprend pas l'implantation d'éléments de magnésium. En variante, l'implantation des éléments dopants pour la formation des couches 591 comprend l'implantation d'éléments de magnésium dans une concentration inférieure à la concentration des éléments dopants de silicium et/ou d'oxygène, par exemple dans une concentration inférieure à 10¹⁷ atomes/cm³. A titre d'exemple, le nombre de cycles réalisés lors de cette étape est égal au nombre de couches 591 et 593 souhaité et défini pour la grille 57.

La figure 6 est une vue en coupe, partielle et schématique, d'un exemple d'un transistor HEMT 61 selon un cinquième mode de réalisation.

Le transistor 61 illustré en figure 6 est similaire au transistor 43 illustré en figure 2 à la différence près que le transistor 61 comprend une région métallique 63 s'étendant sur une partie de la surface de la couche isolante 33. La région métallique s'étend par exemple entre les couches isolantes 35 et 33. A titre d'exemple, la région métallique 63 s'étend entre la métallisation de contact de grille 27 et la métallisation de contact de drain 31 sans être en contact avec les métallisations 27 et 31.

A titre d'exemple, la région métallique 63 est à base de nitrure de titane et/ou de titane, et/ou de tantale, et/ou un alliage de tungstène et de tantale et/ou un alliage de tungstène et de titane et/ou d'un alliage d'aluminium et de cuivre. La région métallique 63 est par exemple en le même matériau que la métallisation de contact de grille 27.

La région métallique 63 a, comme la région 41, par exemple pour fonction de modifier le profil de la distribution du champ électrique du bord de la grille, situé du côté du drain (le bord droit de la grille en figure 6), et de réduire le pic du champ électrique critique, augmentant ainsi la tension d'avalanche. La région métallique 63 est par exemple appelée "field plate" ou plaque de champ.

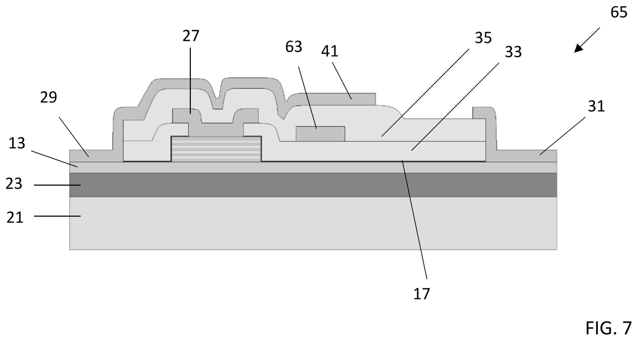

La figure 7 est une vue en coupe, partielle et schématique, d'un exemple d'un transistor 65 HEMT selon un sixième mode de réalisation.

Le transistor 65 illustré en figure 7 est similaire au transistor HEMT 43 illustré en figure 2 à la différence près que, dans le procédé de fabrication du transistor 65, les métallisations de contact de source 29 et de drain 31 ont été formées après la formation de la métallisation de contact de grille 27 alors que dans le procédé de fabrication du transistor 41, les métallisations de contacts de source 29 et de drain 31 ont été formées avant la formation de la métallisation de contact de grille 27.

Plus particulièrement, dans cet exemple, le transistor 65 est différent du transistor 43 en ce que les métallisations de contact de source 29 et de drain 31 traversent la couche 35 et en ce que la couche 35 recouvre la métallisation de contact de grille 27.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les deuxièmes, troisièmes et quatrièmes modes de réalisation illustrés en figures 3, 4 et 5 peuvent être combinés entre eux et aux cinquième et sixième modes de réalisation illustrés aux figures 6 et 7.

En outre, bien que l'on ait décrit ci-dessus un exemple de réalisation dans lequel la grille du transistor est en contact avec la face supérieure de la couche semiconductrice supérieure 13, à titre de variante, la grille peut être séparée de la couche semiconductrice 13 par une couche d'isolant de grille.

Enfin, la mise en oeuvre pratique des modes de réalisation et variantes décrits est à la portée de la personne du métier à partir des indications fonctionnelles données ci-dessus.

## Revendications

1. Transistor (43 ; 61 ; 65) HEMT comportant :
- une première couche semiconductrice (13) ; et
- une grille (45 ; 51 ; 53 ; 57) disposée sur une première face de la première couche semiconductrice (13),
dans lequel la grille (45 ; 51 ; 53 ; 57) comprend une alternance d'au moins deux premières couches (451) et d'au moins trois deuxièmes couches (453), les premières couches (451) étant dopées en magnésium et en au moins l'un des éléments dopants choisi parmi le silicium et l'oxygène et les premières couches (451) ayant une concentration en éléments dopants supérieure à la concentration en éléments dopants dans les deuxièmes couches (453).

2. Transistor selon la revendication 1, dans lequel la grille (45 ; 51 ; 53 ; 57) comprend au moins quatre premières couches (451) et au moins cinq deuxièmes couches (453).

3. Transistor selon la revendication 1 ou 2, dans lequel chaque première couche (451) est en contact avec une deuxième couche (453) sus-jacente et une deuxième couche (453) sous-jacente.

4. Transistor selon l'une quelconque des revendications 1 à 3, dans lequel la concentration en magnésium dans les premières couches (451) est supérieure à 1.10¹⁷ atomes/cm³.

5. Transistor selon l'une quelconque des revendications 1 à 4, dans lequel la concentration en oxygène et/ou en silicium dans les premières couches (451) est supérieure à 1.10¹⁶ atomes/cm³.

6. Transistor selon l'une quelconque des revendications 1 à 5, dans lequel la concentration en magnésium dans les deuxièmes couches (453) est inférieure à 1.10¹⁷ atomes/cm³.

7. Transistor selon l'une quelconque des revendications 1 à 6, dans lequel la face inférieure de la grille (45 ; 51 ; 53 ; 57) correspond à la face inférieure d'une deuxième couche inférieure (453i).

8. Transistor selon l'une quelconque des revendications 1 à 7, dans lequel la face supérieure de la grille (45 ; 51 ; 53) correspond à la face supérieure d'une deuxième couche supérieure (453s).

9. Transistor selon la revendication 8, dans lequel la deuxième couche supérieure (453s) a une épaisseur supérieure aux autres deuxièmes couches (453) de la grille (51 ; 53).

10. Transistor selon la revendication 9, dans lequel la grille (53) comprend, entre la deuxième couche supérieure (453s) et une première couche inférieure (451), une couche en nitrure d'aluminium (55), ladite couche en nitrure d'aluminium (55) étant en contact avec la deuxième couche supérieure (453s).

11. Transistor selon l'une quelconque des revendications 1 à 8, dans lequel les deuxièmes couches (453) ont toutes la même épaisseur.

12. Transistor selon l'une quelconque des revendications 1 à 7, dans lequel la grille (57) comprend en outre une alternance d'au moins deux troisièmes couches (591) et d'au moins trois quatrièmes couches (593), les troisièmes couches (591) étant dopées majoritairement en éléments dopants de silicium et/ou d'oxygène, et les troisièmes couches (591) ayant une concentration en éléments dopants supérieure à la concentration en éléments dopants dans les quatrièmes couches (593),
l'alternance des premières (451) et deuxièmes (453) couches étant disposée dans une partie inférieure (57i) de la grille (57) et l'alternance des troisièmes (591) et quatrièmes (593) couches étant disposée dans une partie supérieure (57s) de la grille (57), et
les premières couches (451) étant dopées majoritairement en éléments dopants de magnésium.

13. Procédé de formation d'un transistor HEMT comportant les étapes successives suivantes :
a) former une première couche semiconductrice (13) ;
b) former au moins deux premières couches (451) en alternance avec au moins trois deuxièmes couches (453) de façon à créer une grille (45 ; 51 ; 53 ; 57) sur une première face de la première couche semiconductrice (13), les premières couches (451) étant dopées en magnésium et en au moins l'un des éléments dopants choisi parmi le silicium et l'oxygène, et les premières couches (451) ayant une concentration en éléments dopants supérieure à la concentration en éléments dopants dans les deuxièmes couches (453).
